(19) 

Europäisches
Patentamt
European
Patent Office
Office européen
des brevets

(11)     EP 4 701 105 A1

(12)                    EUROPEAN PATENT APPLICATION
                   published in accordance with Art. 153(4) EPC

(43) Date of publication:
      25.02.2026  Bulletin 2026/09

(51) International Patent Classification (IPC):
      H04L 1/00 (2006.01)

(21) Application number: 23937207.1

(52) Cooperative Patent Classification (CPC):
      H04L 1/00

(22) Date of filing: 28.09.2023

(86) International application number:
      PCT/CN2023/122827

(87) International publication number:
      WO 2024/234531 (21.11.2024 Gazette 2024/47)

(84) Designated Contracting States:
      AL AT BE BG CH CY CZ DE DK EE ES FI FR GB
      GR HR HU IE IS IT LI LT LU LV MC ME MK MT NL
      NO PL PT RO RS SE SI SK SM TR
      Designated Extension States:
      BA
      Designated Validation States:
      KH MA MD TN

(30) Priority: 17.05.2023  PCT/CN2023/094701

(71) Applicant: Huawei Technologies Co., Ltd.
      Shenzhen, Guangdong 518129 (CN)

(72) Inventors:
      • WANG, Xianbin
        Shenzhen, Guangdong 518129 (CN)
      • ZHANG, Huazi
        Shenzhen, Guangdong 518129 (CN)
      • TONG, Jiajie
        Shenzhen, Guangdong 518129 (CN)
      • QIN, Kangjian
        Shenzhen, Guangdong 518129 (CN)
      • WANG, Jun
        Shenzhen, Guangdong 518129 (CN)

(74) Representative: MERH-IP Matias Erny Reichl
      Hoffmann
      Patentanwälte PartG mbB
      Paul-Heyse-Straße 29
      80336 München (DE)

(54)     **POLAR CODE ENCODING METHOD AND APPARATUS**

(57)     This application provides a polar code encoding method and an apparatus, to reduce implementation complexity of encoding while ensuring encoding performance. The method includes: determining a threshold based on a length N of a first reliability sequence and a length M of an encoded bit sequence, where N is a positive integer power of 2, and M is a positive integer; determining a first sub-sequence and a second sub-sequence based on a rate matching method of the encoded bit sequence and the first reliability sequence; determining, based on the threshold, the first sub-sequence, the second sub-sequence, the rate matching method of the encoded bit sequence, and the first reliability sequence, K information bits corresponding to the encoded bit sequence, where K is a positive integer less than M; and performing polar encoding to obtain the encoded bit sequence.

$\underline{500}$

Determine a threshold based on a length N of a first reliability sequence and a length M of an encoded bit sequence, where N is a positive integer power of 2, and M is a positive integer — 510

Determine a first sub-sequence and a second sub-sequence based on a rate matching method of the encoded bit sequence and the first reliability sequence — 520

Determine, based on the threshold, the first sub-sequence, the second sub-sequence, the rate matching method, and the first reliability sequence, K information bits corresponding to the encoded bit sequence, where K is a positive integer less than M — 530

Perform polar encoding based on the K information bits to obtain the encoded bit sequence — 540

FIG. 5

EP 4 701 105 A1

## Description

This application claims priority to Chinese Patent Application No. PCT/CN2023/094701, filed with the China National Intellectual Property Administration on May 17, 2023 and entitled "POLAR CODE ENCODING METHOD AND APPARATUS", which is incorporated herein by reference in its entirety.

## TECHNICAL FIELD

This application relates to the communication field, and more specifically, to a polar code encoding method and an apparatus.

## BACKGROUND

Polar codes (polar codes) are a first channel coding scheme that can be strictly proved to achieve a Shannon channel capacity, and have advantages of good decoding performance and low complexity. Currently, the polar codes have been determined by the 3rd generation partnership project (3rd generation partnership project, 3GPP) as a control channel coding scheme for uplink transmission and downlink transmission in a 5G enhanced mobile broadband (enhanced mobile broadband, eMBB) scenario.

In a polar code construction process, when a polar code is of a non-mother code length, a rate matching method needs to be determined, and positions of an information bit and a frozen bit are determined based on the rate matching method and a reliability sequence. In the past research, a plurality of rate matching schemes are proposed in both academia and industry. In a natural order (nature order, NAT)-based rate matching scheme, both shortened (shorten) bits and punctured (puncture) bits are consecutive, and implementation is simple. However, the rate matching scheme causes a change in a reliability order corresponding to a bit sequence. If a polar code is constructed still based on a pre-stored reliability sequence, decoding performance is poor in some cases, and a bad point is easily formed.

## SUMMARY

This application provides a polar code encoding method and an apparatus, to improve encoding performance.

According to a first aspect, a polar code encoding method is provided. The method may be performed by a chip or a chip system on a terminal device side or a network device side. The method includes: determining a threshold based on a length N of a first reliability sequence and a length M of an encoded bit sequence, where N is a positive integer power of 2, and M is a positive integer; determining a first sub-sequence and a second sub-sequence based on a rate matching method of the encoded bit sequence and the first reliability sequence; determining, based on the threshold, the first sub-sequence, the second sub-sequence, the rate matching method, and the first reliability sequence, K information bits corresponding to the encoded bit sequence, where K is a positive integer less than M; and performing polar encoding to obtain the encoded bit sequence.

According to the foregoing technical solution, the K information bits corresponding to the encoded bit sequence may be determined based on the determined threshold, first sub-sequence, and second sub-sequence, and the first reliability sequence. In this encoding process, a rate matching method such as sequential puncturing or sequential shortening may still be used. This is easy to implement and can avoid a bad point. In this way, encoding performance can be improved.

With reference to the first aspect, in some implementations of the first aspect, the rate matching method includes puncturing, shortening, or repetition.

With reference to the first aspect, in some implementations of the first aspect, determining the threshold based on the length N of the first reliability sequence and the length M of the encoded bit sequence includes: determining the threshold based on the rate matching method of the encoded bit sequence, the length N of the first reliability sequence, and the length M of the encoded bit sequence. Based on this implementation, accuracy of the determined information bit corresponding to the encoded bit sequence can be improved, thereby improving polar code encoding performance.

With reference to the first aspect, in some implementations of the first aspect, if $M/(N/2)$ is greater than or equal to a preset threshold, the threshold is a first value; or if $M/(N/2)$ is less than the preset threshold, the threshold is a second value, where the preset threshold is associated with the rate matching method.

With reference to the first aspect, in some implementations of the first aspect, the first sub-sequence is associated with a reliability sequence corresponding to first N/2 bits in the first reliability sequence, and the second sub-sequence is associated with a reliability sequence corresponding to last N/2 bits in the first reliability sequence.

With reference to the first aspect, in some implementations of the first aspect, determining the first sub-sequence and the second sub-sequence based on the rate matching method of the encoded bit sequence and the first reliability sequence includes: when the rate matching method includes puncturing, removing first N-M bits in the reliability sequence corresponding to the first N/2 bits in the first reliability sequence, to obtain the first sub-sequence, where the second sub-sequence is the reliability sequence corresponding to the last N/2 bits in the first reliability sequence; or when the rate matching method includes shortening, removing last N-M bits in the reliability sequence corresponding to the last N/2 bits in the first reliability sequence, to obtain the second sub-sequence, where the first sub-sequence is the reliability sequence corresponding to the first N/2 bits in the first reliability sequence. Removing the first N-M bits in the reliability sequence corresponding to the first N/2 bits in the first reliability sequence may be understood as removing a bit with a sequence number less than N-M in the reliability sequence corresponding to the first N/2 bits in the first reliability sequence. Removing the last N-M bits in the reliability sequence corresponding to the last N/2 bits in the first reliability sequence may be understood as removing a bit with a sequence number greater than or equal to M in the reliability sequence corresponding to the last N/2 bits in the first reliability sequence.

With reference to the first aspect, in some implementations of the first aspect, determining the first sub-sequence and the second sub-sequence based on the rate matching method of the encoded bit sequence and the first reliability sequence includes: when the rate matching method includes puncturing, removing first N-M bits in the first reliability sequence to obtain a second reliability sequence, and determining the first sub-sequence and the second sub-sequence based on the second reliability sequence; or when the rate matching method includes shortening, removing last N-M bits in the first reliability sequence to obtain a third reliability sequence, and determining the first sub-sequence and the second sub-sequence based on the third reliability sequence.

With reference to the first aspect, in some implementations of the first aspect, determining, based on the threshold, the first sub-sequence, the second sub-sequence, the rate matching method, and the first reliability sequence, the K information bits corresponding to the encoded bit sequence includes: if an $i^{th}$-to-last bit sequence number in a fourth reliability sequence is greater than or equal to the threshold, determining, as the information bit, a bit indicated by a $j^{th}$-to-last bit sequence number in the second sub-sequence, where $1 \leq i \leq K$, and $1 \leq j \leq K$; or if the $i^{th}$-to-last bit sequence number in the fourth reliability sequence is less than the threshold, determining, as the information bit, a bit indicated by a $q^{th}$-to-last bit sequence number in the first sub-sequence, where $1 \leq q \leq K$, the fourth reliability sequence is obtained based on the rate matching method and the first reliability sequence, and when the rate matching method includes puncturing, the fourth reliability sequence includes the second reliability sequence, or when the rate matching method includes shortening, the fourth reliability sequence includes the third reliability sequence.

With reference to the first aspect, in some implementations of the first aspect, determining, based on the threshold, the first sub-sequence, the second sub-sequence, the rate matching method, and the first reliability sequence, the K information bits corresponding to the encoded bit sequence includes: if a last bit sequence number in the fourth reliability sequence is greater than or equal to the threshold, determining, as a $1^{st}$ information bit, a bit indicated by a last bit sequence number in the second sub-sequence; and if a $2^{nd}$-to-last bit sequence number in the fourth reliability sequence is greater than or equal to the threshold, determining, as a $2^{nd}$ information bit, a bit indicated by a $2^{nd}$-to-last bit sequence number in the second sub-sequence; or if the $2^{nd}$-to-last bit sequence number in the fourth reliability sequence is less than the threshold, determining, as the $2^{nd}$ information bit, a bit indicated by a last bit sequence number in the first sub-sequence.

With reference to the first aspect, in some implementations of the first aspect, determining, based on the threshold, the first sub-sequence, the second sub-sequence, the rate matching method, and the first reliability sequence, the K information bits corresponding to the encoded bit sequence includes: if the last bit sequence number in the fourth reliability sequence is less than the threshold, determining, as the $1^{st}$ information bit, the bit indicated by the last bit sequence number in the first sub-sequence; and if the $2^{nd}$-to-last bit sequence number in the fourth reliability sequence is greater than or equal to the threshold, determining, as the $2^{nd}$ information bit, the bit indicated by the last bit sequence number in the second sub-sequence; or if the $2^{nd}$-to-last bit sequence number in the fourth reliability sequence is less than the threshold, determining, as the $2^{nd}$ information bit, a bit indicated by a $2^{nd}$-to-last bit sequence number in the first sub-sequence.

With reference to the first aspect, in some implementations of the first aspect, performing polar encoding based on the K information bits to obtain the encoded bit sequence includes: performing polar encoding based on the K information bits to obtain a polar encoding result; and performing rate matching based on the polar encoding result to obtain the encoded bit sequence.

With reference to the first aspect, in some implementations of the first aspect, the method further includes: determining the rate matching method based on at least two of the length N of the first reliability sequence, the length M of the encoded bit sequence, and the length K of the information bits corresponding to the encoded bit sequence.

According to a second aspect, a communication apparatus is provided. The apparatus may be used in a terminal device or a network device. The apparatus includes: a processing module, configured to determine a threshold based on a length N of a first reliability sequence and a length M of an encoded bit sequence, where N is a positive integer power of 2, and M is a positive integer, where the processing module is further configured to determine a first sub-sequence and a second sub-sequence based on a rate matching method of the encoded bit sequence and the first reliability sequence; and the processing module is further configured to determine, based on the threshold, the first sub-sequence, the second sub-sequence, the rate matching method, and the first reliability sequence, K information bits corresponding to the encoded bit sequence, where K is a positive integer less than M; and an encoding module, configured to perform polar encoding to obtain the encoded bit sequence.

With reference to the second aspect, in some implementations of the second aspect, the rate matching method includes puncturing, shortening, or repetition.

With reference to the second aspect, in some implementations of the second aspect, the processing module is specifically configured to determine the threshold based on the rate matching method of the encoded bit sequence, the length N of the first reliability sequence, and the length M of the encoded bit sequence.

With reference to the second aspect, in some implementations of the second aspect, if M/(N/2) is greater than or equal to a preset threshold, the threshold is a first value; or if M/(N/2) is less than the preset threshold, the threshold is a second value, where the preset threshold is associated with the rate matching method.

With reference to the second aspect, in some implementations of the second aspect, the first sub-sequence is associated with a reliability sequence corresponding to first N/2 bits in the first reliability sequence, and the second sub-sequence is associated with a reliability sequence corresponding to last N/2 bits in the first reliability sequence.

With reference to the second aspect, in some implementations of the second aspect, the processing module is specifically configured to: when the rate matching method includes puncturing, remove first N-M bits in the reliability sequence corresponding to the first N/2 bits in the first reliability sequence, to obtain the first sub-sequence, where the second sub-sequence is the reliability sequence corresponding to the last N/2 bits in the first reliability sequence; or when the rate matching method includes shortening, remove last N-M bits in the reliability sequence corresponding to the last N/2 bits in the first reliability sequence, to obtain the second sub-sequence, where the first sub-sequence is the reliability sequence corresponding to the first N/2 bits in the first reliability sequence.

With reference to the second aspect, in some implementations of the second aspect, the processing module is specifically configured to: when the rate matching method includes puncturing, remove first N-M bits in the first reliability sequence to obtain a second reliability sequence, and determine the first sub-sequence and the second sub-sequence based on the second reliability sequence; or when the rate matching method includes shortening, remove last N-M bits in the first reliability sequence to obtain a third reliability sequence, and determine the first sub-sequence and the second sub-sequence based on the third reliability sequence.

With reference to the second aspect, in some implementations of the second aspect, the processing module is specifically configured to: if an $i^{th}$-to-last bit sequence number in a fourth reliability sequence is greater than or equal to the threshold, determine, as the information bit, a bit indicated by a $j^{th}$-to-last bit sequence number in the second sub-sequence, where $1 \leq i \leq K$, and $1 \leq j \leq K$; or if the $i^{th}$-to-last bit sequence number in the fourth reliability sequence is less than the threshold, determine, as the information bit, a bit indicated by a $q^{th}$-to-last bit sequence number in the first sub-sequence, where $1 \leq q \leq K$, the fourth reliability sequence is obtained based on the rate matching method and the first reliability sequence, and when the rate matching method includes puncturing, the fourth reliability sequence includes the second reliability sequence, or when the rate matching method includes shortening, the fourth reliability sequence includes the third reliability sequence.

With reference to the second aspect, in some implementations of the second aspect, the processing module is specifically configured to: if a last bit sequence number in the fourth reliability sequence is greater than or equal to the threshold, determine, as a $1^{st}$ information bit, a bit indicated by a last bit sequence number in the second sub-sequence; and if a $2^{nd}$-to-last bit sequence number in the fourth reliability sequence is greater than or equal to the threshold, determine, as a $2^{nd}$ information bit, a bit indicated by a $2^{nd}$-to-last bit sequence number in the second sub-sequence; or if the $2^{nd}$-to-last bit sequence number in the fourth reliability sequence is less than the threshold, determine, as the $2^{nd}$ information bit, a bit indicated by a last bit sequence number in the first sub-sequence.

With reference to the second aspect, in some implementations of the second aspect, the processing module is specifically configured to: if the last bit sequence number in the fourth reliability sequence is less than the threshold, determine, as the $1^{st}$ information bit, the bit indicated by the last bit sequence number in the first sub-sequence; and if the $2^{nd}$-to-last bit sequence number in the fourth reliability sequence is greater than or equal to the threshold, determine, as the $2^{nd}$ information bit, the bit indicated by the last bit sequence number in the second sub-sequence; or if the $2^{nd}$-to-last bit sequence number in the fourth reliability sequence is less than the threshold, determine, as the $2^{nd}$ information bit, a bit indicated by a $2^{nd}$-to-last bit sequence number in the first sub-sequence.

With reference to the second aspect, in some implementations of the second aspect, the encoding module is specifically configured to: perform polar encoding based on the K information bits to obtain a polar encoding result; and perform rate matching based on the polar encoding result to obtain the encoded bit sequence.

With reference to the second aspect, in some implementations of the second aspect, the processing module is further configured to determine the rate matching method based on at least two of the length N of the first reliability sequence, the length M of the encoded bit sequence, and the length K of the information bits corresponding to the encoded bit sequence.

According to a third aspect, a communication apparatus is provided, and includes a processor and a memory.

The memory is configured to store a computer program. The processor is configured to execute a part or all of the computer program stored in the memory, for performing the method according to any one of the first aspect or the possible implementations of the first aspect.

According to a fourth aspect, a communication device is provided, and includes an input/output interface and a logic circuit. The input/output interface is configured to obtain input information and/or output information. The logic circuit is configured to perform the method according to any one of the first aspect or the possible implementations of the first aspect, and perform processing and/or generate the output information based on the input information.

According to a fifth aspect, a computer-readable storage medium is provided. The computer-readable medium stores a computer program. When the computer program is run on a computer or a processor, the method according to any one of the first aspect and the possible implementations of the first aspect is performed.

According to a sixth aspect, a computer program product including instructions is provided. When the instructions are executed by a computer, a communication apparatus is enabled to implement the method according to any one of the first aspect and the possible implementations of the first aspect.

The solutions provided in the second aspect to the sixth aspect are used for implementing or cooperatively implementing the method provided in the first aspect, and therefore can achieve beneficial effect the same as or corresponding to those in the first aspect. Details are not described herein again.

**BRIEF DESCRIPTION OF DRAWINGS**

FIG. 1 is a diagram of a communication procedure of a communication system;

FIG. 2 is a diagram of a network architecture to which an embodiment of this application is applicable;

FIG. 3 is a diagram showing encoding of a polar code with a length of 8;

FIG. 4 is a diagram of performance comparison between polar codes constructed based on a new radio (new radio, NR) sequence and polar codes constructed based on Gaussian approximation (Gaussian approximation, GA) during natural-order rate matching;

FIG. 5 is a schematic flowchart of a polar code encoding method according to an embodiment of this application;

FIG. 6 is a diagram of performance simulations respectively corresponding to a rate matching scheme in which reconstruction is performed based on Gaussian approximation and a construction solution according to an embodiment of this application when rate matching is performed in a natural order;

FIG. 7 is a block diagram of a communication apparatus according to an embodiment of this application; and

FIG. 8 is a block diagram of another communication apparatus according to an embodiment of this application.

**DESCRIPTION OF EMBODIMENTS**

The following describes technical solutions of this application with reference to accompanying drawings.

Embodiments of this application may be applied to various communication systems, for example, a wireless local area network (wireless local area network, WLAN) system, a band-internet of things (band-internet of things, IoT) system, a long term evolution (long term evolution, LTE) system, satellite communication, a sidelink (sidelink, SL), a 4th generation (4th generation, 4G) communication system, a 5th generation (5th generation, 5G) communication system, or a new communication system that appears in the future. The communication system includes communication devices, and wireless communication may be performed between the communication devices on an air interface resource. The communication devices may include a network device and a terminal device, and the network device may also be referred to as a base station device.

The terminal device in embodiments of this application may include various handheld devices, vehicle-mounted devices, wearable devices, or computing devices that have a wireless communication function, or other processing devices connected to a wireless modem. The terminal may be a subscriber unit (subscriber unit), user equipment (user equipment, UE), a cellular phone (cellular phone), a smartphone (smartphone), a wireless data card, a personal digital assistant (personal digital assistant, PDA) computer, a tablet computer, a wireless modulator-demodulator (modulator-demodulator, modem), a laptop computer (laptop computer), a machine type communication (machine type communication, MTC) terminal, a wireless terminal in self-driving (self-driving), or the like. The user equipment includes vehicle user equipment. With emergence of internet of things (internet of things, IoT) technologies, more devices that previously do not have a communication function, for example, but not limited to, a household appliance, a transportation vehicle, a tool device, a service device, and a service facility, start to obtain a wireless communication function by being configured with a wireless communication unit, to access a wireless communication network to accept remote control. Such a device has the wireless communication function because the device is configured with the wireless communication unit, and is therefore classified as a wireless communication device. In addition, the terminal device may also be referred to as a mobile station (mobile station, MS), a mobile device, a mobile terminal, a wireless terminal, a handset (handset), a client, a virtual reality (virtual reality, VR) terminal device, an augmented reality (augmented reality, AR) terminal device, a wireless terminal in industrial control, a wireless terminal in self-driving, a wireless terminal in telemedicine, a wireless terminal in a smart grid, a wireless terminal in a smart city (smart city), a wireless terminal in a smart home (smart home), or the like.

In embodiments of this application, an apparatus configured to implement a function of the technical solution may be a terminal device, or may be a chip system that can support the terminal device in implementing the function. The apparatus, for example, a system on chip (system on chip, SoC) or a modem (modem), may be installed in the terminal device. In embodiments of this application, the chip system may include a chip, or may include a chip and another discrete component. In this application, the technical solutions provided in embodiments of this application are described by using an example in which the terminal device is user equipment (UE).

For example, the network device may be an access network device, an evolved NodeB (evolved NodeB, eNB), a radio network controller (radio network controller, RNC), a NodeB (NodeB, NB), a base station controller (base station controller, BSC), a base transceiver station (base transceiver station, BTS), a home base station (home evolved NodeB, or home NodeB, HNB), a baseband unit (baseband unit, BBU), a device that bears a base station function in device to device (device to device, D2D), an access point (access point, AP) in a wireless fidelity (wireless fidelity, Wi-Fi) system, a radio relay node, a wireless backhaul node, a transmission point (transmission point, TP), a transmission reception point (transmission reception point, TRP), or the like; or may be a gNB or a transmission point (for example, a TRP or a TP) in new radio (new radio, NR), or one antenna panel or a group of antenna panels (including a plurality of antenna panels) of a base station in NR; or may be a network node that forms a gNB or a transmission point, for example, a baseband unit (baseband unit, BBU) or a distributed unit (distributed unit, DU). Alternatively, the network device may be a vehicle-mounted device, a wearable device, a network device in a 6G network, a network device in a future evolved PLMN network, a network device deployed on a satellite, or the like. This is not limited. In addition, based on sizes of provided service coverage areas, base stations (base stations, BSs) may be classified into macro base stations for providing a macro cell (macro cell), micro base stations for providing a micro cell (pico cell), and femto base stations for providing a femto cell (femto cell), relay stations, access points, and the like. As a wireless communication technology continuously evolves, a future base station may also use another name.

The network device has abundant product forms. For example, in a product implementation process, a BBU and a radio frequency unit (radio frequency unit, RFU) may be integrated into a same device, and the device is connected to an antenna array through a cable (for example, but not limited to, a feeder). The BBU and the RFU may alternatively be disposed separately, are connected to each other through an optical fiber, and communicate with each other through, for example, but not limited to, a common public radio interface (common public radio interface, CPRI) protocol. In this case, the RFU is usually referred to as a remote radio unit (remote radio unit, RRU), and is connected to the antenna array through the cable. In addition, the RRU may alternatively be integrated with the antenna array. For example, this structure is for an active antenna unit (active antenna unit, AAU) product in a current market.

In addition, the BBU may be further decomposed into a plurality of parts. For example, the BBU may be further divided into a central unit (central unit, CU) and a distributed unit (distributed unit, DU) based on a real-time requirement of a processed service. The CU is responsible for processing a non-real-time protocol and service, and the DU is responsible for processing a physical layer protocol and a real-time service. Further, some physical layer functions may be separated from the BBU or the DU and integrated into an AAU.

Similar to an implementation form of the terminal device, an apparatus configured to implement a function of the technical solution may be a network device, or may be a chip system that can support the network device in implementing the function. The apparatus, for example a system on chip (SoC) or a modem (modem), may be installed in the network device. In embodiments of this application, the chip system may include a chip, or may include a chip and another discrete component.

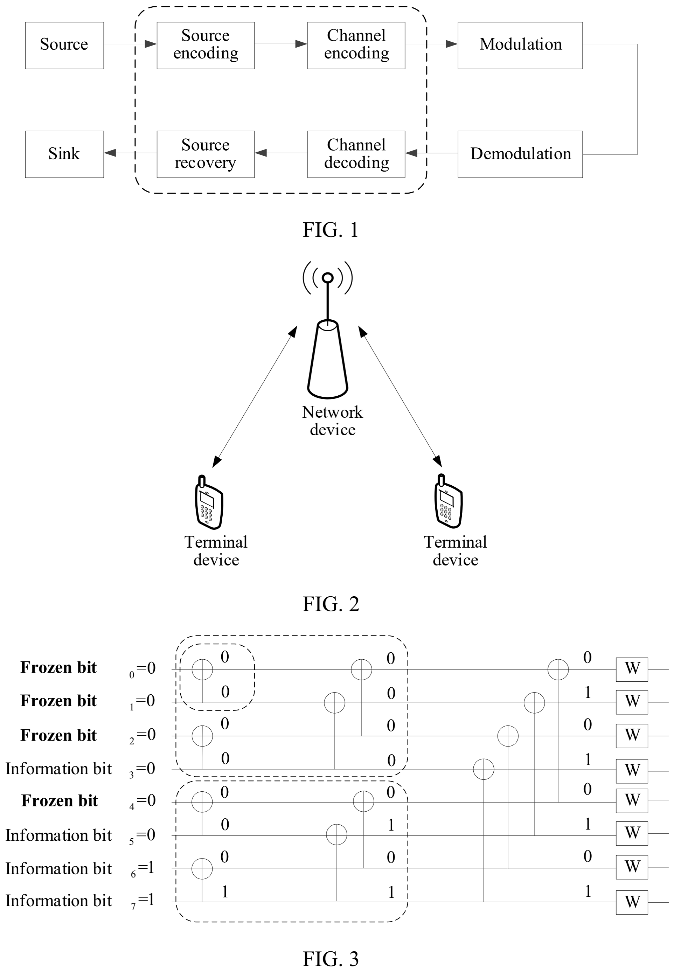

Embodiments of this application may be implemented by using an application-specific integrated circuit (application-specific integrated circuit, ASIC) or a field programmable gate array (field programmable gate array, FPGA), or may be implemented by using program code in software/memory. In a communication procedure of a communication system, embodiments of this application mainly relate to source encoding, channel encoding, channel decoding, and source recovery. FIG. 1 is a diagram of a communication procedure of a communication system.

FIG. 2 is a diagram of a network architecture to which an embodiment of this application is applicable. The network architecture includes a network device and terminal devices. The network device may transmit data or control information to the terminal device, and the terminal device may transmit data or control information to the network device. The network device in embodiments of this application may be a base station.

For ease of understanding of embodiments of this application, the following briefly describes polar code-related technical solutions.

Polar codes are a first channel coding scheme that can be strictly proved to achieve a Shannon channel capacity, and have advantages of good decoding performance and low complexity. Currently, the polar codes have been determined by the 3GPP as a control channel coding scheme for uplink transmission and downlink transmission in a 5G eMBB scenario.

FIG. 3 is a diagram showing encoding of a polar code with a length of 8. An encoding process includes several polar kernel operations, and each polar kernel multiplies two input bits by $\begin{bmatrix} 1 & 0 \\ 1 & 1 \end{bmatrix}$, to obtain two output bits. It can be learned that the polar code is a code constructed based on recursion. The polar code with the length of 8 may be considered as being obtained by coupling two polar codes with a length of 4 by using four polar kernels with a length of 2, and each polar code with a length of 4 may be considered as being obtained by coupling two polar codes with a length of 2 by using two polar kernels with a length of 2. A polar code with a code length of an integer power of 2, for example, a polar code with a code length of 4, 8, 16, 32, or 64 is usually referred to as a polar code with a mother code length.

In a polar code construction process, two objectives need to be completed: first, when a polar code is of a non-mother code length, determining a rate matching method; and second, determining positions of an information bit and a frozen bit based on the rate matching method and a reliability sequence.

1. Rate matching method

During actual application, a length M of a needed polar code is not necessarily an integer power of 2. The polar code is usually referred to as a polar code of a non-mother code length. In this case, some bits need to be removed from a mother code and are not sent. This process is usually referred to as rate matching (rate matching). The rate matching method includes the following two types:

(1) Puncturing (puncture): refers to directly removing some positions from a polar code of a mother code length without sending, thereby generating a bit sequence of any length through polar code encoding. On a decoding side, there is no information amount at the position corresponding to "puncturing", so that a log likelihood ratio (log likelihood ratio, LLR) of a bit at the corresponding position is set to 0.

(2) Shortening (shorten): is another common rate matching method. According to this method, a polar code is designed, so that values at some positions in an encoded bit sequence are fixed, and the fixed values do not need to be transmitted. On a decoding side, a fixed value at a "shortened" position is known to a receiving end, and is usually 0, so that an LLR of a bit at the corresponding position is set to infinity.

2. Position determining of an information bit and a frozen bit

A bit with high reliability is set as an information bit (data), and a bit with low reliability is set as a frozen (frozen) bit. A value of the frozen bit is usually set to 0, which is known to both a transmitting end and a receiving end during actual transmission. In 5G NR, positions of a frozen bit and an information bit in a polar code are determined based on a reliability sequence. For example, when a bit sequence occupies eight bits, the eight bits from left to right are respectively represented as $\mu_0$, $\mu_1$, $\mu_2$, $\mu_3$, $\mu_4$, $\mu_5$, $\mu_6$, and $\mu_7$. If a reliability sequence sorted in ascending order of reliability is [0, 1, 2, 4, 3, 5, 6, 7], $\mu_7$ has the highest reliability, and $\mu_6$ has the second highest reliability. When a polar code with a code length of 8 and four information bits is constructed, $\mu_7$, $\mu_6$, $\mu_5$, and $\mu_3$ are selected as the information bits, and $\mu_4$, $\mu_2$, $\mu_1$, and $\mu_0$ are selected as frozen bits based on the reliability sequence from back to front. The frozen bit may be referred to as a fixed bit.

Because a process of rate matching affects reliability sorting of a polar code, two processes: rate matching and position determining of an information bit and a frozen bit are actually strongly coupled.

3. Natural order-based rate matching scheme

The inventor has studied a plurality of currently known rate matching schemes, including a natural order-based rate matching scheme. In addition, the natural order-based rate matching scheme is the simplest to implement.

The natural order-based rate matching scheme means consecutively performing, in a natural order, puncturing or shortening on a bit sequence corresponding to a polar code. Puncturing is used as an example. When a polar code with a length of 6 needs to be constructed, a polar code with a length of 8 is first constructed, and then first two bits are punctured. When a polar code with a length of 5 needs to be constructed, a polar code with a length of 8 is first constructed, and then first three bits are punctured. When a rate matching method of shortening is used, for a polar code with a length of 7 that needs to be constructed, a polar code with a length of 8 is first constructed, and then u7 is preset to 0, so that x7 in an encoded bit sequence is 0, where x7 is obtained by performing polar encoding on u7; and for a polar code with a length of 6 that needs to be constructed, a polar code with a length of 8 is first constructed, and then u6 and u7 are preset to 0, so that x6 and x7 in an encoded bit sequence are 0, where x6 is obtained by performing polar encoding on u6.

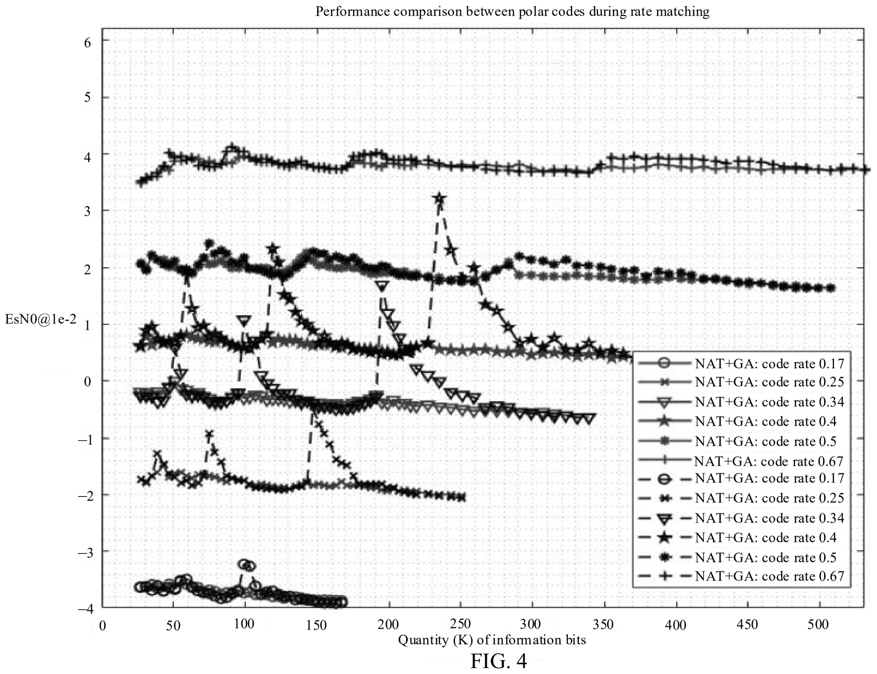

In the natural order-based rate matching scheme, both shortened bits and punctured bits are consecutive, and implementation is simple. However, the natural order-based rate matching scheme causes a change in a reliability order corresponding to the bit sequence. If the polar code is still constructed based on a pre-stored reliability sequence, decoding performance is poor in some cases, and a bad point is easily formed. The "bad point" may be understood as a point at which a signal-to-noise ratio (signal-to-noise ratio, SNR) needed for achieving the same transmission performance suddenly increases. FIG. 4 is a diagram of performance comparison between polar codes constructed based on an NR sequence and polar codes constructed based on Gaussian approximation when rate matching is performed in a natural order, where a horizontal coordinate represents a length K of information bits, and a vertical coordinate represents a signal-to-noise ratio (SNR).

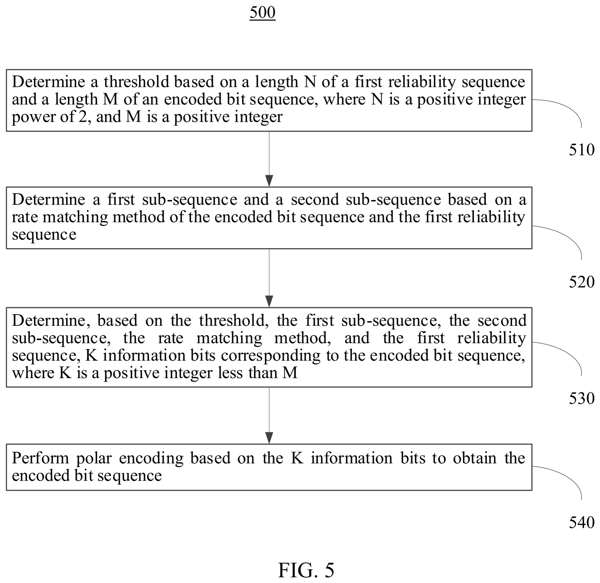

Embodiments of this application provide a polar code encoding method. The polar code encoding method can avoid a bad point. In this way, encoding performance can be improved. FIG. 5 is a schematic flowchart of a polar code encoding method 500 according to an embodiment of this application. The polar code encoding method provided in this embodiment of this application may be performed by a terminal device, or may be performed by a network device, for example, a base station.

510: Determine a threshold based on a length N of a first reliability sequence and a length M of an encoded bit sequence, where the threshold is used for determining K information bits corresponding to the encoded bit sequence, N is a positive integer power of 2, M is a positive integer, and K is a positive integer less than M. N is a mother code length, and M is a length after rate matching.

Optionally, a rate matching method of the encoded bit sequence is determined based on at least two of the length N of the first reliability sequence, the length M of the encoded bit sequence, and the length K of the information bits corresponding to the encoded bit sequence. For example, the rate matching method includes puncturing, shortening, or repetition. If M>N, the rate matching method of the encoded bit sequence is repetition. If M<N and K/M≤7/16, the rate matching method of the encoded bit sequence is puncturing. If M<N and K/M>7/16, the rate matching method of the encoded bit sequence is shortening.

Optionally, the threshold is determined based on the rate matching method of the encoded bit sequence, the length N of the first reliability sequence, and the length M of the encoded bit sequence. In comparison with determining the threshold based on the length N of the first reliability sequence and the length M of the encoded bit sequence, in this optional solution, accuracy of the determined information bit corresponding to the encoded bit sequence can be improved, thereby improving polar code encoding performance. For example, when the rate matching method is repetition, M>N, and the threshold is N/2.

For example, if M/(N/2) is greater than or equal to a preset threshold, the threshold is a first value, where the preset threshold is associated with the rate matching method of the encoded bit sequence, and the rate matching method includes puncturing or shortening. If M/(N/2) is less than the preset threshold, the threshold is a second value. The threshold may be represented by T.

For example, when the rate matching method is puncturing, a value of the preset threshold may be 1.15, 1.125, 1.25, 1.375, or 1.625. The value of the preset threshold varies with a modulation scheme of to-be-transmitted data. In a case in which the rate matching method is puncturing, when the modulation scheme is quadrature phase shift keying (quadrature phase shift keying, QPSK), the value of the preset threshold may be 1.15; when the modulation scheme is quadrature amplitude modulation (quadrature amplitude modulation, QAM) 16, the value of the preset threshold may be 1.125; when the modulation scheme is QAM64, the value of the preset threshold may be 1.25; when the modulation scheme is QAM256, the value of the preset threshold may be 1.375; or when the modulation scheme is QAM1024, the value of the preset threshold may be 1.625.

When the rate matching method is puncturing, and the value of the preset threshold is $1.15$, if M/(N/2) is greater than or equal to 1.15, the threshold T=N/2, and the first value is N/2; or if M/(N/2) is less than 1.15, the threshold T=floor(31/64N), and the second value is floor(31/64N). floor(31/64N) means to take a maximum integer less than or equal to 31/64N.

For another example, when the rate matching method is shortening, the value of the preset threshold may be 1.50, 1.375, or 1.625. The value of the preset threshold varies with a communication scenario. In a case in which the rate matching method is shortening, when the communication scenario is an eMBB scenario, the value of the preset threshold may be 1.50; when the communication scenario is an ultra-reliable and low latency communications (ultra-reliable and low latency communications, uRLLC) scenario, the value of the preset threshold may be 1.375; or when the communication scenario is a massive machine type communication (massive machine type communication, mMTC) scenario, the value of the preset threshold may be 1.625.

When the rate matching method is shortening, and the value of the preset threshold is 1.50, if M/(N/2) is greater than or equal to 1.50, the threshold T=N/2, and the first value is N/2; or if M/(N/2) is less than 1.50, the threshold T=floor(31/64N), and the second value is floor(31/64N).

For example, pseudocode for determining the threshold T is as follows:

> If adopt repetition as the rate matching method
>
>> T=N/2;
>
> else
>
>> if adopt puncture as the rate matching method
>>
>>> if(M/(N/2))$\geq$1.15
>>>
>>>> T=N/2;
>>>>
>>>> else
>>>>
>>>>> T=floor(31/64N);
>>>>
>>>> end
>>>
>>> else
>>>
>>>> if(1.0*M/(N/2))$\geq$1.50
>>>>
>>>>> T=N/2;
>>>>
>>>> else
>>>>
>>>>> T=floor(31/64N);
>>>>
>>>> end
>>>
>>> end
>>
>> end

Optionally, before the threshold is determined, the mother code length N is determined based on the length M of the encoded bit sequence and the length K of the information bits corresponding to the encoded bit sequence. A specific process is as follows:

(1) determining $N_0$, where $N_0$ is a minimum integer power of 2 and is greater than or equal to M, for example, if M=252, $N_0$=256, or for another example, if M=5, $N_0$=8;

(2) calculating $n_1$, where if K/M<9/16 and M<(1+1/8)*$N_0$/2, $n_1$=log2($N_0$)-1; otherwise, $n_1$=log2($N_0$);

(3) calculating $n_2$, $n_2 = \lceil \log 2(K/R_{min}) \rceil$ , where $R_{min}$ = 1/8, and $R_{min}$ represents a supported minimum bit rate;

(4) calculating n, n=max{min{$n_1$, $n_2$, $n_{max}$}, $n_{min}$}, where a minimum mother code length is $2^{nmin}$, a maximum mother code length is $2^{nmax}$, $n_{min}$=5, $n_{max}$=10 during uplink transmission, and $n_{max}$=5 during downlink transmission; and

(5) obtaining the mother code length N based on n, where N=$2^n$.

520: Determine a first sub-sequence and a second sub-sequence based on the rate matching method of the encoded bit sequence and the first reliability sequence, where the first sub-sequence and the second sub-sequence are used for determining the K information bits corresponding to the encoded bit sequence.

Optionally, the first sub-sequence is associated with a reliability sequence corresponding to first N/2 bits in the first reliability sequence, and the second sub-sequence is associated with a reliability sequence corresponding to last N/2 bits in the first reliability sequence. When sequence numbers in the first reliability sequence are 0 to N-1, the first N/2 bits may be understood as a bit with a sequence number less than N/2 in the first reliability sequence, and the last N/2 bits may be understood as a bit with a sequence number greater than or equal to N/2 in the first reliability sequence.

For example, when the rate matching method includes puncturing, first N-M bits in the reliability sequence corresponding to the first N/2 bits in the first reliability sequence are removed, to obtain the first sub-sequence, where the second sub-sequence is the reliability sequence corresponding to the last N/2 bits in the first reliability sequence. It may be understood as that, when the rate matching method is puncturing, the reliability sequence corresponding to the first N/2 bits is determined based on the first reliability sequence, and the first N-M bits in the reliability sequence corresponding to the first N/2 bits are removed, to obtain the first sub-sequence; and the reliability sequence corresponding to the last N/2 bits is determined based on the first reliability sequence, to obtain the second sub-sequence. When the sequence numbers in the first reliability sequence are 0 to N-1, the first N-M bits may be understood as a bit with a sequence number less than N-M in the first reliability sequence. Removing the first N-M bits in the reliability sequence corresponding to the first N/2 bits may be understood as removing the bit with the sequence number less than N-M in the reliability sequence corresponding to the first N/2 bits.

For example, when the rate matching method includes shortening, last N-M bits in the reliability sequence corresponding to the last N/2 bits in the first reliability sequence are removed, to obtain the second sub-sequence, where the first sub-sequence is the reliability sequence corresponding to the first N/2 bits in the first reliability sequence. It may be understood as that, when the rate matching method is shortening, the reliability sequence corresponding to the last N/2 bits is determined based on the first reliability sequence, and the last N-M bits in the reliability sequence corresponding to the last N/2 bits are removed, to obtain the second sub-sequence; and the reliability sequence corresponding to the first N/2 bits is determined based on the first reliability sequence, to obtain the first sub-sequence. Removing the last N-M bits in the reliability sequence corresponding to the last N/2 bits may be understood as removing a bit with a sequence number greater than or equal to M in the reliability sequence corresponding to the last N/2 bits. In this application, a transmitting end may still use a rate matching method such as sequential puncturing or sequential shortening. This is easy to implement and can avoid a bad point. In this way, encoding performance can be improved.

For example, when the rate matching method includes repetition, the first sub-sequence is the reliability sequence corresponding to the first N/2 bits in the first reliability sequence, where the second sub-sequence is the reliability sequence corresponding to the last N/2 bits in the first reliability sequence.

For example, if N=16, M=12, and a first reliability sequence is [0, 1, 2, 4, 8, 3, 5, 9, 6, 10, 12, 7, 11, 13, 14, 15], a reliability sequence corresponding to the first N/2 bits is [0, 1, 2, 4, 3, 5, 6, 7], and a reliability sequence corresponding to the last N/2 bits is [8, 9, 10, 12, 11, 13, 14, 15]. When a rate matching method is puncturing, first four bits in [0, 1, 2, 4, 3, 5, 6, 7] are removed, to obtain a first sub-sequence [4, 5, 6, 7] and a second sub-sequence [8, 9, 10, 12, 11, 13, 14, 15]. When a rate matching method is shortening, last four bits in [8, 9, 10, 12, 11, 13, 14, 15] are removed, to obtain a second sub-sequence [8, 9, 10, 11] and a first sub-sequence [0, 1, 2, 4, 3, 5, 6, 7]. When a rate matching method is repetition, a first sub-sequence is [0, 1, 2, 4, 3, 5, 6, 7], and a second sub-sequence is [8, 9, 10, 12, 11, 13, 14, 15].

For example, when the rate matching method includes puncturing, first N-M bits in the first reliability sequence are removed, to obtain a second reliability sequence; and the first sub-sequence and the second sub-sequence are determined based on the second reliability sequence. For example, a reliability sequence corresponding to first M-N/2 bits in the second reliability sequence is determined as the first sub-sequence, and a reliability sequence corresponding to last N/2 bits in the second reliability sequence is determined as the second sub-sequence. For example, N=16, M=12, and a first reliability sequence is [0, 1, 2, 4, 8, 3, 5, 9, 6, 10, 12, 7, 11, 13, 14, 15]. When a rate matching method includes puncturing, first four bits in the first reliability sequence are removed, to obtain a second reliability sequence [4, 8, 5, 9, 6, 10, 12, 7, 11, 13, 14, 15]; and a reliability sequence [4, 5, 6, 7] corresponding to first M-N/2 bits in the second reliability sequence is determined as a first sub-sequence, and a reliability sequence [8, 9, 10, 12, 11, 13, 14, 15] corresponding to last N/2 bits in the second reliability sequence is determined as a second sub-sequence.

For example, when the rate matching method includes shortening, last N-M bits in the first reliability sequence are removed, to obtain a third reliability sequence; and the first sub-sequence and the second sub-sequence are determined based on the third reliability sequence. For example, a reliability sequence corresponding to first N/2 bits in the third reliability sequence is determined as the first sub-sequence, and a reliability sequence corresponding to last M-N/2 bits in the second reliability sequence is determined as the second sub-sequence. For example, N=16, M=12, and a first reliability sequence is [0, 1, 2, 4, 8, 3, 5, 9, 6, 10, 12, 7, 11, 13, 14, 15]. When a rate matching method includes shortening, last four bits in the first reliability sequence are removed, to obtain a third reliability sequence [0, 1, 2, 4, 8, 3, 5, 9, 6, 10, 7, 11]; and a reliability sequence [0, 1, 2, 4, 3, 5, 6, 7] corresponding to first N/2 bits in the third reliability sequence is determined as a first sub-sequence, and a reliability sequence [8, 9, 10, 11] corresponding to last M-N/2 bits in the third reliability sequence is determined as a second sub-sequence.

530: Determine, based on the threshold, the first sub-sequence, the second sub-sequence, the rate matching method of the encoded bit sequence, and the first reliability sequence, the K information bits corresponding to the encoded bit sequence.

Optionally, if an $i^{th}$-to-last bit sequence number in a fourth reliability sequence is greater than or equal to the threshold, a bit indicated by a $j^{th}$-to-last bit sequence number in the second sub-sequence is determined as the information bit, where $1 \leq i \leq K$, and $1 \leq j \leq K$; or if the $i^{th}$-to-last bit sequence number in the fourth reliability sequence is less than the threshold, a bit indicated by a $q^{th}$-to-last bit sequence number in the first sub-sequence is determined as the information bit, where $1 \leq q \leq K$, the fourth reliability sequence is obtained based on the rate matching method and the first reliability sequence, and when the rate matching method includes puncturing, the fourth reliability sequence includes the second reliability sequence, or when the rate matching method includes shortening, the fourth reliability sequence includes the third reliability sequence. The $i^{th}$-to-last bit sequence number may be understood as a bit sequence number indicated by an $i^{th}$-to-last position.

For example, if a last bit sequence number in the fourth reliability sequence is greater than or equal to the threshold, a bit indicated by a last bit sequence number in the second sub-sequence is determined as a $1^{st}$ information bit; and if a $2^{nd}$-to-last bit sequence number in the fourth reliability sequence is greater than or equal to the threshold, a bit indicated by a $2^{nd}$-to-last bit sequence number in the second sub-sequence is determined as a $2^{nd}$ information bit; or if the $2^{nd}$-to-last bit sequence number in the fourth reliability sequence is less than the threshold, a bit indicated by a last bit sequence number in the first sub-sequence is determined as the $2^{nd}$ information bit, until the K information bits are determined.

For example, if the last bit sequence number in the fourth reliability sequence is less than the threshold, the bit indicated by the last bit sequence number in the first sub-sequence is determined as the $1^{st}$ information bit; and if the $2^{nd}$-to-last bit sequence number in the fourth reliability sequence is greater than or equal to the threshold, the bit indicated by the last bit sequence number in the second sub-sequence is determined as the $2^{nd}$ information bit; or if the $2^{nd}$-to-last bit sequence number in the fourth reliability sequence is less than the threshold, a bit indicated by a $2^{nd}$-to-last bit sequence number in the first sub-sequence is determined as the $2^{nd}$ information bit, until the K information bits are determined.

For example, N=16, M=12, K=4, and a first reliability sequence is [0, 1, 2, 4, 8, 3, 5, 9, 6, 10, 12, 7, 11, 13, 14, 15]. Because M<N, and K/M≤7/16, it is determined that a rate matching method is puncturing. Because M/(N/2) is greater than or equal to 1.15, it is determined that a threshold T=N/2=8. First four bits in the first reliability sequence are removed, to obtain a fourth reliability sequence (a second reliability sequence) [4, 8, 5, 9, 6, 10, 12, 7, 11, 13, 14, 15]; and it is determined that a first sub-sequence is [4, 5, 6, 7], and a second sub-sequence is [8, 9, 10, 12, 11, 13, 14, 15]. A process of determining, based on the threshold, the first sub-sequence, the second sub-sequence, and the fourth reliability sequence, four information bits corresponding to the encoded bit sequence is as follows:

(1) when a bit sequence number 15 (or referred to as a reliability order of the bit) indicated by a last position in the fourth reliability sequence is greater than the threshold 8, determining, as a $1^{st}$ information bit, a bit 15 indicated by a last bit sequence number in the second sub-sequence;
(2) when a bit sequence number 14 indicated by a $2^{nd}$-to-last position in the fourth reliability sequence is greater than or equal to the threshold 8, determining, as a $2^{nd}$ information bit, a bit 14 indicated by a $2^{nd}$-to-last bit sequence number in the second sub-sequence;
(3) when a bit sequence number 13 indicated by a $3^{rd}$-to-last position in the fourth reliability sequence is greater than or equal to the threshold 8, determining, as a $3^{rd}$ information bit, a bit 13 indicated by a $3^{rd}$-to-last bit sequence number in the second sub-sequence; and
(4) when a bit sequence number 11 indicated by a $4^{th}$-to-last position in the fourth reliability sequence is greater than or equal to the threshold 8, determining, as a $4^{th}$ information bit, a bit 11 indicated by a $4^{th}$-to-last bit sequence number in the second sub-sequence.

Optionally, if an $i^{th}$-to-last bit sequence number in a fourth reliability sequence is greater than the threshold, a bit indicated by a $j^{th}$-to-last bit sequence number in the second sub-sequence is determined as the information bit, where $1 \leq i \leq K$, and $1 \leq j \leq K$; or if the $i^{th}$-to-last bit sequence number in the fourth reliability sequence is less than or equal to the threshold, a bit indicated by a $q^{th}$-to-last bit sequence number in the first sub-sequence is determined as the information bit, where $1 \leq q \leq K$, the fourth reliability sequence is obtained based on the rate matching method and the first reliability sequence, and when the rate matching method includes puncturing, the fourth reliability sequence includes the second reliability sequence, or when the rate matching method includes shortening, the fourth reliability sequence includes the third reliability sequence.

For example, if a last bit sequence number in the fourth reliability sequence is greater than the threshold, a bit indicated by a last bit sequence number in the second sub-sequence is determined as a $1^{st}$ information bit; and if a $2^{nd}$-to-last bit sequence number in the fourth reliability sequence is greater than the threshold, a bit indicated by a $2^{nd}$-to-last bit sequence number in the second sub-sequence is determined as a $2^{nd}$ information bit; or if the $2^{nd}$-to-last bit sequence number in the fourth reliability sequence is less than or equal to the threshold, a bit indicated by a last bit sequence number in the first sub-sequence is determined as the $2^{nd}$ information bit, until the K information bits are determined.

For example, if the last bit sequence number in the fourth reliability sequence is less than or equal to the threshold, the bit indicated by the last bit sequence number in the first sub-sequence is determined as the $1^{st}$ information bit; and if the $2^{nd}$-to-last bit sequence number in the fourth reliability sequence is greater than the threshold, the bit indicated by the last bit sequence number in the second sub-sequence is determined as the $2^{nd}$ information bit; or if the $2^{nd}$-to-last bit sequence number in the fourth reliability sequence is less than or equal to the threshold, a bit indicated by a $2^{nd}$-to-last bit sequence number in the first sub-sequence is determined as the $2^{nd}$ information bit, until the K information bits are determined.

For example, pseudocode for determining, based on the threshold, the first sub-sequence, the second sub-sequence, and the fourth reliability sequence, the K information bits corresponding to the encoded bit sequence is as follows:

$$\overline{Q}_1^N = \overline{Q}^N (\text{val} < N/2), \quad i_1 = N/2 - 1;$$

$$\overline{Q}_2^N = \overline{Q}^N \setminus \overline{Q}_1^N, \quad i_2 = N/2 - 1;$$

$$\overline{Q}_I^N = [];$$

For n=N−1 to N−K;

    If $\overline{Q}^N(n) < T$;

$$\overline{Q}_I^N = \overline{Q}_I^N \overline{Q}_1^N (i_1);$$

$$i_1 = i_1 - 1;$$

   else

$$\overline{Q}_I^N = \overline{Q}_I^N \overline{Q}_2^N (i_2);$$

$$i_2 = i_2 - 1;$$

    end

  end

$$\overline{Q}_F^N = \overline{Q}^N (n) \setminus \overline{Q}_I^N$$

$\overline{Q}^N(n)$ represents the fourth reliability sequence; $\overline{Q}_1^N$ represents the first sub-sequence, and $i_1$ represents an index of a sequence number in the first sub-sequence; $\overline{Q}_2^N$ represents the second sub-sequence, and $i_2$ represents an index of a sequence number in the second sub-sequence; $\overline{Q}_I^N$ represents an information bit set; $\overline{Q}_F^N$ represents a frozen bit set; $\overline{Q}_I^N = \overline{Q}_I^N \overline{Q}_1^N (i_1)$ represents adding one bit to the information bit set based on the first sub-sequence; and $\overline{Q}_I^N = \overline{Q}_I^N \overline{Q}_2^N (i_2)$ represents adding one bit to the information bit set based on the second sub-sequence.

The first reliability sequence and the fourth reliability sequence are sorted in ascending order of reliability. Optionally, the first reliability sequence and the fourth reliability sequence may alternatively be sorted in descending order of reliability. Optionally, when the fourth reliability sequence is sorted in descending order of reliability, if an $i^{th}$ bit sequence number in the fourth reliability sequence is greater than or equal to the threshold, a bit indicated by a $j^{th}$ bit sequence number in the second sub-sequence is determined as the information bit, where $1 \leq i \leq K$, and $1 \leq j \leq K$; or if the $i^{th}$ bit sequence number in the fourth reliability sequence is less than the threshold, a bit indicated by a $q^{th}$ bit sequence number in the first sub-sequence is determined as the information bit, where $1 \leq q \leq K$.

For example, if a $1^{st}$ bit sequence number in the fourth reliability sequence is greater than or equal to the threshold, a bit indicated by a $1^{st}$ bit sequence number in the second sub-sequence is determined as the $1^{st}$ information bit; and if a $2^{nd}$ bit sequence number in the fourth reliability sequence is greater than or equal to the threshold, a bit indicated by a $2^{nd}$ bit sequence number in the second sub-sequence is determined as the $2^{nd}$ information bit; or if the $2^{nd}$ bit sequence number in the fourth reliability sequence is less than the threshold, a bit indicated by a $1^{st}$ bit sequence number in the first sub-sequence is determined as the $2^{nd}$ information bit, until the K information bits are determined.

For example, if the $1^{st}$ bit sequence number in the fourth reliability sequence is less than the threshold, the bit indicated by the $1^{st}$ bit sequence number in the first sub-sequence is determined as the $1^{st}$ information bit; and if the $2^{nd}$ bit sequence number in the fourth reliability sequence is greater than or equal to the threshold, the bit indicated by the $1^{st}$ bit sequence number in the second sub-sequence is determined as the $2^{nd}$ information bit; or if the $2^{nd}$ bit sequence number in the fourth reliability sequence is less than the threshold, a bit indicated by a $2^{nd}$ bit sequence number in the first sub-sequence is determined as the 2<sup>nd</sup> information bit, until the K information bits are determined.

540: Perform polar encoding to obtain the encoded bit sequence. Specifically, the polar encoding is performed based on the K information bits to obtain the encoded bit sequence. Optionally, the polar encoding is performed based on the K information bits to obtain a polar encoding result; and rate matching is performed based on the polar encoding result to obtain the encoded bit sequence.

For example, after the K information bits are determined, remaining N-K bits are set as frozen bits; and the polar encoding is performed on the information bit and the frozen bit, to obtain a polar encoding result with the length of N. When the rate matching method is puncturing, an encoded bit corresponding to first N-M bits in the polar encoding result with the length of N is removed, to obtain the encoded bit sequence with the length of M; when the rate matching method is shortening, an encoded bit corresponding to last N-M bits in the polar encoding result with the length of N is removed, to obtain the encoded bit sequence with the length of M; or when the rate matching method is repetition, a last one encoded bit in the polar encoding result with the length of N is repeated for M-N times, to obtain the encoded bit sequence with the length of M.

Optionally, after obtaining the encoded bit sequence by using the technical solutions provided in this application, the transmitting end transmits the encoded bit sequence to a receiving end. Correspondingly, the receiving end receives the encoded bit sequence from the transmitting end, and performs polar decoding on the encoded bit sequence. The transmitting end may be a terminal device, and the receiving end may be a network device. Alternatively, the transmitting end may be a network device, and the receiving end may be a terminal device.

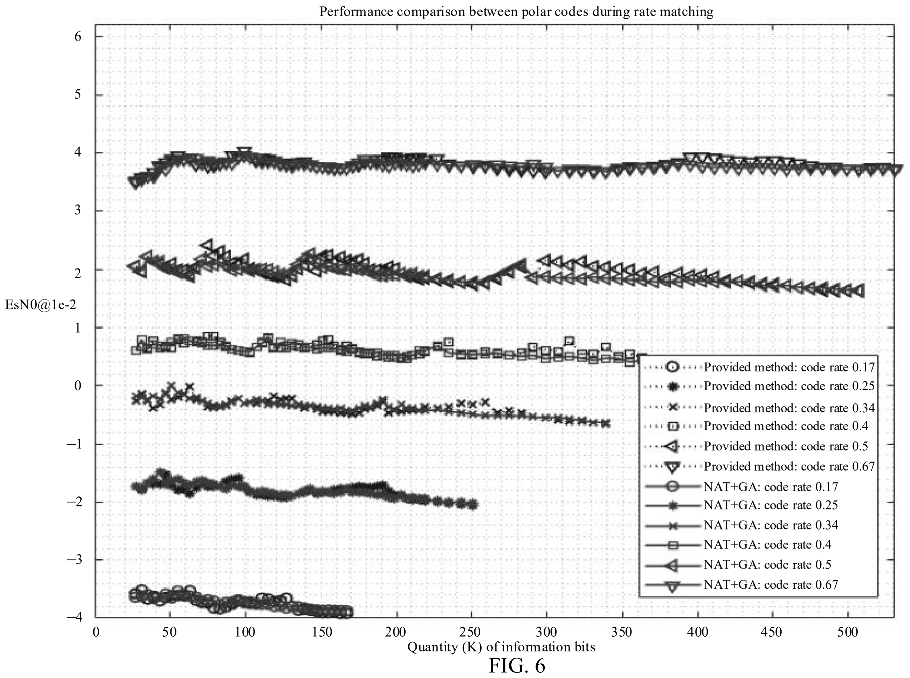

FIG. 6 is a diagram of performance simulations respectively corresponding to a rate matching scheme in which reconstruction is performed based on Gaussian approximation and a construction solution according to an embodiment of this application when rate matching is performed in a natural order. In the figure, a horizontal coordinate represents a length K of information bits, and a vertical coordinate represents a signal-to-noise ratio SNR. A "provided method" is the construction solution provided in embodiments of this application. An online computing solution based on Gaussian approximation has high implementation complexity in practical application, but can be used as an upper bound of theoretical performance. However, in the construction solution in embodiments of this application, online computing is not needed. The construction solution in embodiments of this application is easy to implement, and can reduce implementation complexity of polar code encoding while ensuring encoding performance.

The foregoing describes the data transmission method provided in embodiments of this application. The following describes entities for performing the foregoing polar code encoding method.

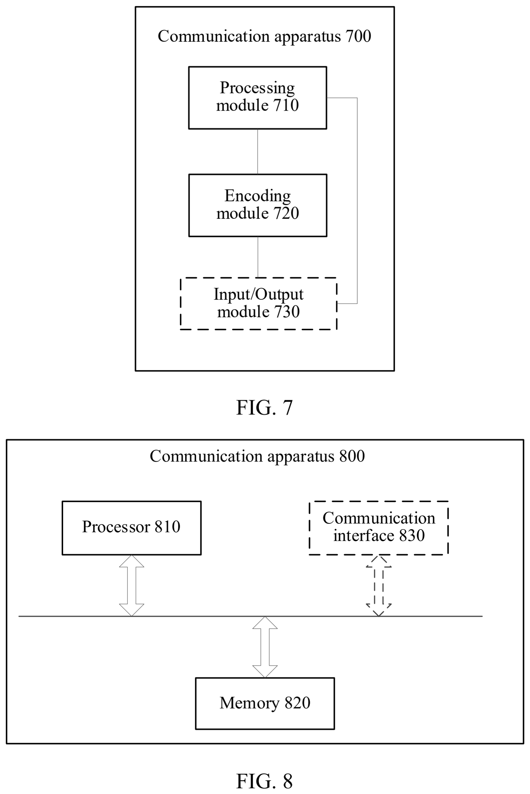

FIG. 7 is a block diagram of a communication apparatus 700 according to an embodiment of this application. The apparatus may be used or deployed in the terminal device or the network device in the method embodiments of this application. The communication apparatus 700 includes:

a processing module 710, configured to determine a threshold based on a length N of a first reliability sequence and a length M of an encoded bit sequence, where N is a positive integer power of 2, and M is a positive integer, where the processing module 710 is further configured to determine a first sub-sequence and a second sub-sequence based on a rate matching method of the encoded bit sequence and the first reliability sequence; and

the processing module 710 is further configured to determine, based on the threshold, the first sub-sequence, the second sub-sequence, the rate matching method, and the first reliability sequence, K information bits corresponding to the encoded bit sequence, where K is a positive integer less than M; and

an encoding module 720, configured to perform polar encoding to obtain the encoded bit sequence.

Optionally, the communication apparatus 700 further includes an input/output module 730, configured to obtain to-be-encoded information and output the encoded bit sequence.

Optionally, the rate matching method includes puncturing, shortening, or repetition.

Optionally, the processing module 710 is specifically configured to determine the threshold based on the rate matching method of the encoded bit sequence, the length N of the first reliability sequence, and the length M of the encoded bit sequence.

Optionally, if M/(N/2) is greater than or equal to a preset threshold, the threshold is a first value; or if M/(N/2) is less than the preset threshold, the threshold is a second value, where the preset threshold is associated with the rate matching method.

Optionally, the first sub-sequence is associated with a reliability sequence corresponding to first N/2 bits in the first reliability sequence, and the second sub-sequence is associated with a reliability sequence corresponding to last N/2 bits in the first reliability sequence.

Optionally, the processing module 710 is specifically configured to: when the rate matching method includes puncturing, remove first N-M bits in the reliability sequence corresponding to the first N/2 bits in the first reliability sequence, to obtain the first sub-sequence, where the second sub-sequence is the reliability sequence corresponding to the last N/2 bits in the first reliability sequence; or when the rate matching method includes shortening, remove last N-M bits in the reliability sequence corresponding to the last N/2 bits in the first reliability sequence, to obtain the second sub-sequence, where the first sub-sequence is the reliability sequence corresponding to the first N/2 bits in the first reliability sequence.

Optionally, the processing module 710 is specifically configured to: when the rate matching method includes puncturing, remove first N-M bits in the first reliability sequence to obtain a second reliability sequence, and determine the first sub-sequence and the second sub-sequence based on the second reliability sequence; or

when the rate matching method includes shortening, remove last N-M bits in the first reliability sequence to obtain a third reliability sequence, and determine the first sub-sequence and the second sub-sequence based on the third reliability sequence.

Optionally, the processing module 710 is specifically configured to: if an $i^{th}$-to-last bit sequence number in a fourth reliability sequence is greater than or equal to the threshold, determine, as the information bit, a bit indicated by a $j^{th}$-to-last bit sequence number in the second sub-sequence, where $1 \leq i \leq K$, and $1 \leq j \leq K$; or if the $i^{th}$-to-last bit sequence number in the fourth reliability sequence is less than the threshold, determine, as the information bit, a bit indicated by a $q^{th}$-to-last bit sequence number in the first sub-sequence, where $1 \leq q \leq K$, the fourth reliability sequence is obtained based on the rate matching method and the first reliability sequence, and when the rate matching method includes puncturing, the fourth reliability sequence includes the second reliability sequence, or when the rate matching method includes shortening, the fourth reliability sequence includes the third reliability sequence.

Optionally, the processing module 710 is specifically configured to: if a last bit sequence number in the fourth reliability sequence is greater than or equal to the threshold, determine, as a $1^{st}$ information bit, a bit indicated by a last bit sequence number in the second sub-sequence; and if a $2^{nd}$-to-last bit sequence number in the fourth reliability sequence is greater than or equal to the threshold, determine, as a $2^{nd}$ information bit, a bit indicated by a $2^{nd}$-to-last bit sequence number in the second sub-sequence; or if the $2^{nd}$-to-last bit sequence number in the fourth reliability sequence is less than the threshold, determine, as the $2^{nd}$ information bit, a bit indicated by a last bit sequence number in the first sub-sequence.

Optionally, the processing module 710 is specifically configured to: if the last bit sequence number in the fourth reliability sequence is less than the threshold, determine, as the $1^{st}$ information bit, the bit indicated by the last bit sequence number in the first sub-sequence; and if the $2^{nd}$-to-last bit sequence number in the fourth reliability sequence is greater than or equal to the threshold, determine, as the $2^{nd}$ information bit, the bit indicated by the last bit sequence number in the second sub-sequence; or if the $2^{nd}$-to-last bit sequence number in the fourth reliability sequence is less than the threshold, determine, as the $2^{nd}$ information bit, a bit indicated by a $2^{nd}$-to-last bit sequence number in the first sub-sequence.

Optionally, the encoding module 720 is specifically configured to: perform polar encoding based on the K information bits to obtain a polar encoding result; and perform rate matching based on the polar encoding result to obtain the encoded bit sequence.

Optionally, the processing module 710 is further configured to determine the rate matching method based on at least two of the length N of the first reliability sequence, the length M of the encoded bit sequence, and the length K of the information bits corresponding to the encoded bit sequence.

FIG. 8 is a block diagram of another communication apparatus 800 according to an embodiment of this application. The communication apparatus 800 includes a processor 810, a memory 820, and a communication interface 830.

The memory 820 is configured to store a computer program.

The processor 810 is coupled to the memory 820 through the communication interface 830. The processor 810 is configured to invoke and run a part or all of the computer program stored in the memory 820, to implement the method in embodiments of this application. The communication apparatus may be used in a first device or a second device in embodiments of this application. Optionally, the processor 810 and the memory 820 are integrated together.

The processor 810 may be an integrated circuit chip, and has a signal processing capability. In an implementation process, steps in the foregoing method embodiments may be implemented by using a hardware integrated logic circuit in the processor, or by using instructions in a form of software. The processor may alternatively be a general-purpose processor, a digital signal processor (digital signal processor, DSP), an ASIC, an FPGA or another programmable logic device, a discrete gate or a transistor logic device, or a discrete hardware component. The processor may implement or perform the methods, the steps, and logical block diagrams that are disclosed in embodiments of this application. The general-purpose processor may be a microprocessor, or the processor may be any conventional processor or the like. The steps in the method disclosed with reference to embodiments of this application may be directly performed and completed by a hardware decoding processor, or may be performed and completed by using a combination of hardware in the decoding processor and a software module. The software module may be located in a mature storage medium in the art, for example, a random access memory, a flash memory, a read-only memory, a programmable read-only memory, an electrically erasable programmable memory, or a register. The storage medium is located in the memory, and a processor reads information in the memory and completes the steps in the foregoing method in combination with hardware of the processor.

Optionally, an embodiment of this application further provides a communication device. The communication device includes an input/output interface and a logic circuit. The input/output interface is configured to obtain input information and/or output information. The logic circuit is configured to perform the method in any one of the foregoing method embodiments, and perform processing and/or generate output information based on the input information.

An embodiment of this application further provides a computer-readable storage medium. The computer-readable storage medium stores a computer program for implementing the method in the foregoing method embodiments. When the computer program is run on a computer, the method in the foregoing method embodiments is implemented.

An embodiment of this application further provides a computer program product. The computer program product includes computer program code. When the computer program code is run on a computer, the method in the foregoing method embodiments is performed.

An embodiment of this application further provides a chip, including a processor. The processor is coupled to a memory, and the memory is configured to store a computer program. The processor is configured to invoke the computer program stored in the memory, to enable the chip to implement the method in the foregoing method embodiments.

It should be understood that, in embodiments of this application, numbers "first", "second", and the like are merely used for distinguishing between different objects, for example, to distinguish between different sub-sequences or values, and constitute no limitation on the scope of embodiments of this application. This is not limited in embodiments of this application.

A person of ordinary skill in the art may be aware that, in combination with the examples described in embodiments disclosed in this specification, units and algorithm steps may be implemented by electronic hardware or a combination of computer software and electronic hardware. Whether such functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for detailed working processes of the foregoing systems, apparatuses, and units, reference may be made to corresponding processes in the foregoing method embodiments. Details are not described herein again.

In the several embodiments provided in this application, it should be understood that the disclosed system, apparatus, and method may be implemented in other manners. For example, the described apparatus embodiments are merely examples. For example, division into the units is merely logical function division. There may be another division manner during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. A part or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

When the functions are implemented in the form of a software functional unit and sold or used as an independent product, the functions may be stored in a computer-readable storage medium. Based on such an understanding, the technical solutions of this application essentially, or the part contributing to a conventional technology, or some of the technical solutions may be implemented in the form of a software product. The computer software product is stored in a storage medium, and includes a plurality of instructions for indicating a computer device (which may be a personal computer, a server, or a network device) to perform all or a part of the steps of the methods described in embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

**Claims**

1. A polar code encoding method, comprising:

    determining a threshold based on a length N of a first reliability sequence and a length M of an encoded bit sequence, wherein N is a positive integer power of 2, and M is a positive integer;
    determining a first sub-sequence and a second sub-sequence based on a rate matching method of the encoded bit sequence and the first reliability sequence;
    determining, based on the threshold, the first sub-sequence, the second sub-sequence, the rate matching method, and the first reliability sequence, K information bits corresponding to the encoded bit sequence, wherein K is a positive integer less than M; and
performing polar encoding to obtain the encoded bit sequence.

2. The method according to claim 1, wherein the rate matching method comprises puncturing, shortening, or repetition.

3. The method according to claim 1 or 2, wherein determining the threshold based on the length N of the first reliability sequence and the length M of the encoded bit sequence comprises:
determining the threshold based on the rate matching method of the encoded bit sequence, the length N of the first reliability sequence, and the length M of the encoded bit sequence.

4. The method according to claim 3, wherein

if $M/(N/2)$ is greater than or equal to a preset threshold, the threshold is a first value; or
if $M/(N/2)$ is less than the preset threshold, the threshold is a second value, wherein the preset threshold is associated with the rate matching method.

5. The method according to any one of claims 1 to 4, wherein the first sub-sequence is associated with a reliability sequence corresponding to first N/2 bits in the first reliability sequence, and the second sub-sequence is associated with a reliability sequence corresponding to last N/2 bits in the first reliability sequence.

6. The method according to any one of claims 1 to 5, wherein determining the first sub-sequence and the second sub-sequence based on the rate matching method of the encoded bit sequence and the first reliability sequence comprises:

when the rate matching method comprises puncturing, removing first N-M bits in the reliability sequence corresponding to the first N/2 bits in the first reliability sequence, to obtain the first sub-sequence, wherein the second sub-sequence is the reliability sequence corresponding to the last N/2 bits in the first reliability sequence; or
when the rate matching method comprises shortening, removing last N-M bits in the reliability sequence corresponding to the last N/2 bits in the first reliability sequence, to obtain the second sub-sequence, wherein the first sub-sequence is the reliability sequence corresponding to the first N/2 bits in the first reliability sequence.

7. The method according to any one of claims 1 to 5, wherein determining the first sub-sequence and the second sub-sequence based on the rate matching method of the encoded bit sequence and the first reliability sequence comprises:

when the rate matching method comprises puncturing, removing first N-M bits in the first reliability sequence to obtain a second reliability sequence, and
determining the first sub-sequence and the second sub-sequence based on the second reliability sequence; or
when the rate matching method comprises shortening, removing last N-M bits in the first reliability sequence to obtain a third reliability sequence, and
determining the first sub-sequence and the second sub-sequence based on the third reliability sequence.

8. The method according to claim 7, wherein determining, based on the threshold, the first sub-sequence, the second sub-sequence, the rate matching method, and the first reliability sequence, the K information bits corresponding to the encoded bit sequence comprises:

if an $i$th-to-last bit sequence number in a fourth reliability sequence is greater than or equal to the threshold, determining, as the information bit, a bit indicated by a $j$th-to-last bit sequence number in the second sub-sequence, wherein $1 \leq i \leq K$, and $1 \leq j \leq K$; or
if the $i$th-to-last bit sequence number in the fourth reliability sequence is less than the threshold, determining, as the information bit, a bit indicated by a $q$th-to-last bit sequence number in the first sub-sequence, wherein $1 \leq q \leq K$, the fourth reliability sequence is obtained based on the rate matching method and the first reliability sequence, and when the rate matching method comprises puncturing, the fourth reliability sequence comprises the second reliability sequence, or when the rate matching method comprises shortening, the fourth reliability sequence comprises the third reliability sequence.

9. The method according to claim 8, wherein determining, based on the threshold, the first sub-sequence, the second sub-sequence, the rate matching method, and the first reliability sequence, the K information bits corresponding to the encoded bit sequence comprises:

if a last bit sequence number in the fourth reliability sequence is greater than or equal to the threshold, determining, as a $1^{st}$ information bit, a bit indicated by a last bit sequence number in the second sub-sequence; and
if a $2^{nd}$-to-last bit sequence number in the fourth reliability sequence is greater than or equal to the threshold, determining, as a $2^{nd}$ information bit, a bit indicated by a $2^{nd}$-to-last bit sequence number in the second sub-sequence; or
if the $2^{nd}$-to-last bit sequence number in the fourth reliability sequence is less than the threshold, determining, as the $2^{nd}$ information bit, a bit indicated by a last bit sequence number in the first sub-sequence.

10. The method according to claim 8 or 9, wherein determining, based on the threshold, the first sub-sequence, the second sub-sequence, the rate matching method, and the first reliability sequence, the K information bits corresponding to the encoded bit sequence comprises:

if the last bit sequence number in the fourth reliability sequence is less than the threshold, determining, as the $1^{st}$ information bit, the bit indicated by the last bit sequence number in the first sub-sequence; and
if the $2^{nd}$-to-last bit sequence number in the fourth reliability sequence is greater than or equal to the threshold, determining, as the $2^{nd}$ information bit, the bit indicated by the last bit sequence number in the second sub-sequence; or
if the $2^{nd}$-to-last bit sequence number in the first fourth reliability sequence is less than the threshold, determining, as the $2^{nd}$ information bit, a bit indicated by a $2^{nd}$-to-last bit sequence number in the first sub-sequence.

11. The method according to any one of claims 1 to 10, wherein performing polar encoding based on the K information bits to obtain the encoded bit sequence comprises:

performing polar encoding based on the K information bits to obtain a polar encoding result; and
performing rate matching based on the polar encoding result to obtain the encoded bit sequence.

12. The method according to any one of claims 1 to 11, wherein the method further comprises:
determining the rate matching method based on at least two of the length N of the first reliability sequence, the length M of the encoded bit sequence, and the length K of the information bits corresponding to the encoded bit sequence.

13. A communication apparatus, comprising:

a processing module, configured to determine a threshold based on a length N of a first reliability sequence and a length M of an encoded bit sequence, wherein N is a positive integer power of 2, and M is a positive integer, wherein
the processing module is further configured to determine a first sub-sequence and a second sub-sequence based on a rate matching method of the encoded bit sequence and the first reliability sequence; and
the processing module is further configured to determine, based on the threshold, the first sub-sequence, the second sub-sequence, the rate matching method, and the first reliability sequence, K information bits corresponding to the encoded bit sequence, wherein K is a positive integer less than M; and
an encoding module, configured to perform polar encoding to obtain the encoded bit sequence.

14. The apparatus according to claim 13, wherein the rate matching method comprises puncturing, shortening, or repetition.

15. The apparatus according to claim 13 or 14, wherein
the processing module is specifically configured to determine the threshold based on the rate matching method of the encoded bit sequence, the length N of the first reliability sequence, and the length M of the encoded bit sequence.

16. The apparatus according to claim 15, wherein

if M/(N/2) is greater than or equal to a preset threshold, the threshold is a first value; or
if M/(N/2) is less than the preset threshold, the threshold is a second value, wherein the preset threshold is associated with the rate matching method.

17. The apparatus according to any one of claims 13 to 16, wherein the first sub-sequence is associated with a reliability sequence corresponding to first N/2 bits in the first reliability sequence, and the second sub-sequence is associated with a reliability sequence corresponding to last N/2 bits in the first reliability sequence.

18. The apparatus according to any one of claims 13 to 17, wherein the processing module is specifically configured to:

when the rate matching method comprises puncturing, remove first N-M bits in the reliability sequence corresponding to the first N/2 bits in the first reliability sequence, to obtain the first sub-sequence, wherein the second sub-sequence is the reliability sequence corresponding to the last N/2 bits in the first reliability sequence; or
when the rate matching method comprises shortening, remove last N-M bits in the reliability sequence corresponding to the last N/2 bits in the first reliability sequence, to obtain the second sub-sequence, wherein the first sub-sequence is the reliability sequence corresponding to the first N/2 bits in the first reliability sequence.

19. The apparatus according to any one of claims 13 to 17, wherein the processing module is specifically configured to:

when the rate matching method comprises puncturing, remove first N-M bits in the first reliability sequence to obtain a second reliability sequence, and
determine the first sub-sequence and the second sub-sequence based on the second reliability sequence; or
when the rate matching method comprises shortening, remove last N-M bits in the first reliability sequence to obtain a third reliability sequence, and
determine the first sub-sequence and the second sub-sequence based on the third reliability sequence.

20. The apparatus according to claim 19, wherein the processing module is specifically configured to:

if an $i^{th}$-to-last bit sequence number in a fourth reliability sequence is greater than or equal to the threshold, determine, as the information bit, a bit indicated by a $j^{th}$-to-last bit sequence number in the second sub-sequence, wherein $1 \leq i \leq K$, and $1 \leq j \leq K$; or
if the $i^{th}$-to-last bit sequence number in the fourth reliability sequence is less than the threshold, determine, as the information bit, a bit indicated by a $q^{th}$-to-last bit sequence number in the first sub-sequence, wherein $1 \leq q \leq K$, the fourth reliability sequence is obtained based on the rate matching method and the first reliability sequence, and when the rate matching method comprises puncturing, the fourth reliability sequence comprises the second reliability sequence, or when the rate matching method comprises shortening, the fourth reliability sequence comprises the third reliability sequence.

21. The apparatus according to claim 20, wherein the processing module is specifically configured to:

if a last bit sequence number in the fourth reliability sequence is greater than or equal to the threshold, determine, as a $1^{st}$ information bit, a bit indicated by a last bit sequence number in the second sub-sequence; and
if a $2^{nd}$-to-last bit sequence number in the fourth reliability sequence is greater than or equal to the threshold, determine, as a $2^{nd}$ information bit, a bit indicated by a $2^{nd}$-to-last bit sequence number in the second sub-sequence; or
if the $2^{nd}$-to-last bit sequence number in the fourth reliability sequence is less than the threshold, determine, as the $2^{nd}$ information bit, a bit indicated by a last bit sequence number in the first sub-sequence.

22. The apparatus according to claim 20 or 21, wherein the processing module is specifically configured to:

if the last bit sequence number in the fourth reliability sequence is less than the threshold, determine, as the $1^{st}$ information bit, the bit indicated by the last bit sequence number in the first sub-sequence; and
if the $2^{nd}$-to-last bit sequence number in the fourth reliability sequence is greater than or equal to the threshold, determine, as the $2^{nd}$ information bit, the bit indicated by the last bit sequence number in the second sub-sequence; or
if the $2^{nd}$-to-last bit sequence number in the fourth reliability sequence is less than the threshold, determine, as the $2^{nd}$ information bit, a bit indicated by a $2^{nd}$-to-last bit sequence number in the first sub-sequence.

23. The apparatus according to any one of claims 13 to 22, wherein the encoding module is specifically configured to:

perform polar encoding based on the K information bits to obtain a polar encoding result; and

**EP 4 701 105 A1**

perform rate matching based on the polar encoding result to obtain the encoded bit sequence.

24. The apparatus according to any one of claims 13 to 23, wherein
the processing module is further configured to determine the rate matching method based on at least two of the length N of the first reliability sequence, the length M of the encoded bit sequence, and the length K of the information bits corresponding to the encoded bit sequence.

25. A communication apparatus, comprising a processor and a memory, wherein the memory is configured to store a computer program, and the processor is configured to execute a part or all of the computer program stored in the memory, for performing the method according to any one of claims 1 to 12.

26. A communication device, comprising an input/output interface and a logic circuit, wherein

the input/output interface is configured to obtain input information and/or output information; and
the logic circuit is configured to perform the method according to any one of claims 1 to 12, and perform processing and/or generate the output information based on the input information.

27. A computer-readable storage medium, wherein

the computer-readable medium stores a computer program; and
when the computer program is run on a computer, the method according to any one of claims 1 to 12 is performed.

28. A computer program product, comprising a computer program, wherein when the computer program is executed, the method according to any one of claims 1 to 12 is implemented.

**19**

FIG. 1

FIG. 2

FIG. 3

Performance comparison between polar codes during rate matching

FIG. 4

500

Determine a threshold based on a length N of a first reliability sequence and a length M of an encoded bit sequence, where N is a positive integer power of 2, and M is a positive integer

510

Determine a first sub-sequence and a second sub-sequence based on a rate matching method of the encoded bit sequence and the first reliability sequence

520

Determine, based on the threshold, the first sub-sequence, the second sub-sequence, the rate matching method, and the first reliability sequence, K information bits corresponding to the encoded bit sequence, where K is a positive integer less than M

530

Perform polar encoding based on the K information bits to obtain the encoded bit sequence

540

FIG. 5

FIG. 6

Communication apparatus 700

Processing
module 710

Encoding
module 720

Input/Output
module 730

FIG. 7

Communication apparatus 800

Processor 810

Communication
interface 830

Memory 820

FIG. 8

## INTERNATIONAL SEARCH REPORT

| International application No. |
| --- |
| **PCT/CN2023/122827** |

| A. CLASSIFICATION OF SUBJECT MATTER |
| --- |
| H04L1/00(2006.01)i |
| According to International Patent Classification (IPC) or to both national classification and IPC |

| B. FIELDS SEARCHED |
| --- |
| Minimum documentation searched (classification system followed by classification symbols) |
| IPC: H04L H04W H03M |
| Documentation searched other than minimum documentation to the extent that such documents are included in the fields searched |
| Electronic data base consulted during the international search (name of data base and, where practicable, search terms used) |
| CNTXT, WPABS, ENTXT, ENTXTC, VEN: 极化码, 母码, 可靠, 编码, 速率, 匹配, 缩短, 打孔, 重复, 序列, 门限, 阈值, 信息, 固定, 冻结, 位, 第一, 第二, 子序列, polar code, mother code, reliable, encod+, rate, match, shorten, puncture+, repetition, sequence, threshold, information, fixed, frozen, bit, first, second, subsequence |

| C. DOCUMENTS CONSIDERED TO BE RELEVANT |
| --- |

| Category* | Citation of document, with indication, where appropriate, of the relevant passages | Relevant to claim No. |
| --- | --- | --- |
| X | US 2023113448 A1 (HUAWEI TECHNOLOGIES CO., LTD.) 13 April 2023 (2023-04-13) description, paragraphs 54-113 | 1-28 |
| X | CN 107342843 A (HUAWEI TECHNOLOGIES CO., LTD.) 10 November 2017 (2017-11-10) description, paragraphs 74-157 | 1-28 |
| A | CN 109672497 A (POTEVIO INFORMATION TECHNOLOGY CO., LTD.) 23 April 2019 (2019-04-23) entire document | 1-28 |
| A | CN 110166167 A (HUAWEI TECHNOLOGIES CO., LTD.) 23 August 2019 (2019-08-23) entire document | 1-28 |
| A | WO 2023273815 A1 (HUAWEI TECHNOLOGIES CO., LTD.) 05 January 2023 (2023-01-05) entire document | 1-28 |

☐ Further documents are listed in the continuation of Box C. ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **15 January 2024** | **20 January 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/122827**

| Patent document cited in search report | | | Publication date (day/month/year) | Patent family member(s) | | | Publication date (day/month/year) |
|---|---|---|---|---|---|---|---|
| US | 2023113448 | A1 | 13 April 2023 | WO | 2021254291 | A1 | 23 December 2021 |
| | | | | EP | 4156524 | A1 | 29 March 2023 |
| | | | | CN | 113810060 | A | 17 December 2021 |
| CN | 107342843 | A | 10 November 2017 | EP | 3550750 | A1 | 09 October 2019 |
| | | | | US | 2023198660 | A1 | 22 June 2023 |
| | | | | ES | 2894999 | T3 | 16 February 2022 |
| | | | | KR | 20190099078 | A | 23 August 2019 |
| | | | | JP | 2020505820 | A | 20 February 2020 |
| | | | | AU | 2018206034 | A1 | 22 August 2019 |
| | | | | JP | 2021064956 | A | 22 April 2021 |
| | | | | US | 2020351009 | A1 | 05 November 2020 |
| | | | | US | 2021234631 | A1 | 29 July 2021 |
| | | | | US | 2019123853 | A1 | 25 April 2019 |
| | | | | WO | 2018127041 | A1 | 12 July 2018 |
| | | | | US | 2019280804 | A1 | 12 September 2019 |
| | | | | RU | 2019124520 | A | 05 February 2021 |
| | | | | EP | 3996284 | A1 | 11 May 2022 |
| | | | | CN | 109889304 | A | 14 June 2019 |
| | | | | IN | 201937031423 | A | 11 October 2019 |
| | | | | ID | 201907888 | A | 08 November 2019 |
| | | | | VN | 67897 | A | 30 January 2020 |
| | | | | CN | 117375765 | A | 09 January 2024 |
| CN | 109672497 | A | 23 April 2019 | None | | | |
| CN | 110166167 | A | 23 August 2019 | WO | 2019158031 | A1 | 22 August 2019 |
| WO | 2023273815 | A1 | 05 January 2023 | CN | 115567151 | A | 03 January 2023 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2023094701 W